# EUROPÄISCHE PATENTSCHRIFT

(11) **EP 2 883 111 B1**
(45) Veröffentlichungstag und Bekanntmachung des Hinweises auf die Patenterteilung: **07.11.2018**
(21) Anmeldenummer: 12751473.5
(22) Anmeldetag: 13.08.2012
(51) Int. Cl.: G03F 7/20, G02B 7/00, G02B 7/182

(54) **OPTISCHE ANORDNUNG, OPTISCHES MODUL UND VERFAHREN ZUM LAGERICHTIGEN POSITIONIEREN EINES OPTISCHEN MODULS IN EINEM GEHÄUSE**
OPTICAL ASSEMBLY, OPTICAL MODULE AND METHOD OF ALIGNED POSITIONING OF A MODULE IN A HOUSING
ENSEMBLE OPTIQUE, MODULE OPTIQUE ET MÉTHODE DE POSITIONNEMENT ALIGNÉ D'UN MODULE OPTIQUE DANS UNE ENCEINTE

(43) Veröffentlichungstag der Anmeldung: 17.06.2015
(73) Patentinhaber: TRUMPF Lasersystems for Semiconductor Manufacturing GmbH, 71254 Ditzingen (DE)
(72) Erfinder: LAMBERT, Martin, 71404 Korb (DE)
(74) Vertreter: Kohler Schmid Möbus Patentanwälte
(86) Internationale Anmeldenummer: PCT/EP2012/065800
(87) Internationale Veröffentlichungsnummer: WO 2014/026704

(56) Entgegenhaltungen:
- US-A- 5 638 223
- US-A1- 2008 104 828
- US-A1- 2010 026 976
- US-A1- 2010 051 832
- US-A1- 2010 208 230

## Beschreibung

Die vorliegende Erfindung betrifft eine optische Anordnung mit einem optischen Modul und mit einem Gehäuse, insbesondere einem Vakuum-Gehäuse, ein optisches Modul, sowie ein Verfahren zum lagerichtigen Positionieren des optischen Moduls in dem Gehäuse.

Während des Betriebes von optischen Elementen bzw. von optischen Baugruppen in optischen Anordnungen können diese verschmutzen, da sich kontaminierende Stoffe an deren optischen Oberflächen ablagern. Dieses Problem tritt insbesondere bei so genannten EUV-Lithographiesystemen auf, bei denen für die Erzeugung von EUV-Strahlung ein Laserstrahl eines Treiberlasersystems auf eine Zielposition gerichtet wird, an der ein Target-Material bereitgestellt wird, welches bei der Bestrahlung mit dem Laserstrahl in einen Plasma-Zustand übergeht und hierbei EUV-Strahlung emittiert. Ein solches EUV-Lithographiesystem ist beispielsweise in der US 8,173,985 B2 beschrieben. Bei der Bestrahlung mit dem Laserstrahl wird typischer Weise ein Teil des Target-Materials (z.B. Zinn) verdampft, der sich auf den optischen Oberflächen von optischen Elementen ablagert, die in der Nähe der Zielposition angeordnet sind.

Um diesem Problem zu begegnen, wird als Treiberlaser einer solchen optischen Anordnung in der Regel ein CO₂-Laser verwendet. CO₂-Laserstrahlung wird aufgrund ihrer hohen Wellenlänge von ca. 10,6 µm auch von reflektierenden optischen Elementen reflektiert, die eine vergleichsweise raue optische Oberfläche aufweisen, wie sie durch Zinn-Ablagerungen hervorgerufen wird. Die Verwendung eines Treiberlasers in Form eines CO₂-Lasers ermöglicht zudem bei bestimmten TargetMaterialien, z.B. Zinn, eine hohe Konversionseffizienz zwischen der Eingangsleistung des Treiberlasers und Ausgangsleistung der EUV-Strahlung.

Bei dem oben beschriebenen EUV-Lithographiesystem und auch bei anderen optischen Anordnungen kann es von Zeit zu Zeit erforderlich sein, Wartungsarbeiten an den optischen Elementen bzw. den optischen Baugruppen vorzunehmen, beispielsweise um die optischen Elemente zu reinigen oder gegen nicht verschmutzte optische Elemente auszutauschen. Ist eine optische Baugruppe in einem geschlossenen Gehäuse angeordnet, z.B. in einem Vakuum-Gehäuse, lässt sich dieses in der Regel nicht ohne größeren Aufwand demontieren. Ist ein direkter Zugang zu der optischen Baugruppe beispielsweise mit Hilfe von Wartungsöffnungen bauraumbedingt nicht möglich, ist für die Durchführung der Wartungsarbeiten eine Entnahme des optischen Moduls bzw. der optischen Baugruppe aus dem Gehäuse erforderlich.

Bei einer Entnahme des optischen Moduls aus einem Gehäuse tritt das Problem auf, dass das optische Modul, genauer gesagt die optischen Elemente des optischen Moduls, nach dem Abschluss der Wartungsarbeiten wieder mit hoher Genauigkeit relativ zu den in dem Gehäuse verbliebenen optischen Elementen positioniert werden müssen. Bei einem Vakuum-Gehäuse können zudem vakuumbedingte Deformationen an den Gehäusewänden auftreten, welche die lagerichtige Positionierung der optischen Elemente bzw. des optischen Moduls erschweren. Für die lagerichtige Positionierung der optischen Elemente des optischen Moduls nach dem Abschluss der Wartungsarbeiten ist daher typischer Weise eine aufwändige und langwierige Justage erforderlich.

In der US 2010/0208230 A1 sind ein Verfahren zum Anordnen eines optischen Moduls in einer Messapparatur und eine Messapparatur beschrieben. Das optische Modul ist in einer Vakuum-Kammer angeordnet und kann mit Hilfe von Positioniervorrichtungen, die Auflager für das optische Modul bilden, in drei Raumrichtungen verschoben sowie gedreht werden. Mit Hilfe der Positioniervorrichtungen kann eine vorgegebene Position eines aus dem optischen Modul austretenden Ausgangsstrahls in Bezug auf eine Detektorfläche eingestellt werden.

In der US 2010/0051832 A1 ist eine EUV-Lichtquelle beschrieben, welche einen Positionierungsmechanismus zur Positionierung einer Kammer oder einer Wartungseinrichtung einer Kammer an einem vorgegebenen Ort sowie einen Bewegungsmechanismus zur Bewegung der Kammer oder der Wartungseinrichtung der Kammer zwischen dem vorgegebenen Ort und einem Wartungsbereich umfasst.

### Aufgabe der Erfindung

Es ist die Aufgabe der vorliegenden Erfindung, eine optische Anordnung mit einem optischen Modul und mit einem Gehäuse, ein optisches Modul sowie ein Verfahren anzugeben, welche die lagerichtige Positionierung der optischen Elemente des optischen Moduls in dem Gehäuse vereinfachen.

### Gegenstand der Erfindung

Diese Aufgabe wird erfindungsgemäß gelöst durch eine optische Anordnung, umfassend: ein optisches Modul mit einem ersten Trägerkörper, an dem mindestens ein insbesondere reflektierendes optisches Element und eine Mehrzahl von ersten Lagerungselementen angebracht ist, ein Gehäuse, insbesondere ein Vakuum-Gehäuse, mit einem zweiten Trägerkörper für mindestens ein weiteres optisches Element, welches zur Reflexion von EUV-Strahlung ausgebildet ist, wobei an dem zweiten Trägerkörper eine Mehrzahl von zweiten Lagerungselementen angebracht ist, sowie eine Bewegungseinrichtung zur Verschiebung des ersten Trägerkörpers relativ zum zweiten Trägerkörper entlang einer insbesondere vertikalen Bewegungsrichtung zwischen einer Entnahmeposition, von der das optische Modul aus dem Gehäuse entnehmbar ist, und einer Lagerungsposition, in der die Bewegungseinrichtung die ersten Lagerungselemente gegen die zweiten Lagerungselemente andrückt.

Durch das Andrücken der ersten Lagerungselemente gegen die zweiten Lagerungselemente in der Lagerungsposition kann eine reproduzierbare, lagerichtige Positionierung des mindestens einen optischen Elements des optischen Moduls relativ zu mindestens einem optischen Element hergestellt werden, welches in dem (Vakuum-)Gehäuse an dem zweiten Trägerkörper angebracht ist, ohne dass zu diesem Zweck eine aufwändige Justage erforderlich ist. Durch die Anbringung der Lagerungselemente an den Trägerkörpern kann zudem eine gehäuseinterne Trägerstruktur realisiert werden, um die optischen Elemente zu lagern, was sich insbesondere bei Vakuum-Gehäusen als günstig erwiesen hat Der Trägerkörper des optischen Moduls und die starr mit diesem verbundenen optischen Elemente sind durch die Lagerung an mindestens drei Paaren von Lagerungselementen statisch bestimmt und somit reproduzierbar in dem Gehäuse gelagert.

In der Lagerungsposition kann das optische Modul typischer Weise nicht aus dem Gehäuse entnommen werden, da die Lagerungselemente ineinander greifen bzw. die Lagerflächen aneinander anliegen. Um das optische Modul aus dem Gehäuse zu entnehmen, wird dieses von der Lagerungsposition in eine Entnahmeposition verbracht, in der die Lagerungselemente nicht mehr ineinander eingreifen und genügend Bauraum zur Entnahme zur Verfügung steht. Die Bewegungsrichtung (und damit auch die Andruck-Richtung der Lagerelemente) verläuft hierbei bevorzugt in vertikaler Richtung, um eine querkraftfreie Anordnung zu gewährleisten.

Die Entnahmeposition kann sich insbesondere unterhalb der Lagerungsposition befinden. In diesem Fall drückt die Bewegungseinrichtung die Lagerungselemente des optischen Moduls im Betrieb der optischen Anordnung gegen die Wirkung der Schwerkraft von unten nach oben gegen die Lagerungselemente des ortsfesten Trägerkörpers an. Um den Trägerkörper von der Lagerungsposition in die Entnahmeposition zu verbringen, wird der Trägerkörper mit Hilfe der Bewegungseinrichtung abgesenkt. Der Bewegungsweg des optischen Moduls zwischen der Entnahmeposition und der Lagerungsposition kann bei wenigen Millimetern liegen. Die Entnahme des optischen Moduls aus dem Gehäuse ausgehend von der Entnahmeposition kann durch eine insbesondere in horizontaler Richtung verlaufende Verschiebebewegung erfolgen.

Bei dem weiteren optischen Element, welches zur Reflexion von EUV-Strahlung ausgebildet ist, kann es sich insbesondere um einen so genannten Kollektor-Spiegel für die an einer Zielposition durch die Bestrahlung eines Target-Materials erzeugte EUV-Strahlung handeln. Um EUV-Strahlung zu reflektieren, ist an dem weiteren optischen Element typischer Weise eine Mehrlagen-Beschichtung angebracht, die eine Mehrzahl von alternierenden Schichten mit abwechselnd hohem und niedrigem Brechungsindex aufweist.

In einer Ausführungsform umfasst der erste Trägerkörper einen Trägerschlitten, der mit einer Mehrzahl von Rollen und/oder Gleitelementen versehen ist. Mit Hilfe der Rollen kann der Trägerschlitten ausgehend von der Entnahmeposition auf einfache Weise entlang einer typischer Weise horizontal verlaufenden Auflagefläche des Gehäuses verschoben bzw. gerollt werden, wodurch sich die Entnahme des optischen Moduls aus dem Gehäuse vereinfacht. Sobald eine der Rollen bei der Verschiebebewegung den Kontakt zum Gehäuse verliert, kann das Gewicht des optischen Moduls von zusätzlichen Stützrollen, Führungsstangen und/oder von einer Hilfsfläche aufgenommen werden, die sich an die Auflagefläche des Gehäuses anschließt. Auch die Verwendung von Gleitelementen, z.B. in Form von Kufen, ist möglich.

In einer Weiterbildung dieser Ausführungsform liegen die Rollen und/oder die Gleitelemente in der Entnahmeposition auf einer Auflagefläche am Gehäuse auf und sind in der Lagerungsposition von der Auflagefläche beabstandet. Aus der Entnahmeposition kann das optische Modul mit Hilfe der Rollen bzw. der Gleitelemente entlang der typischer Weise horizontal verlaufenden Auflagefläche verschoben werden. In der Lagerungsposition besteht kein direkter Kontakt der Rollen bzw. der Gleitelemente zu dem Gehäuse, so dass sich Deformationen des Gehäuses nicht unmittelbar auf das optische Modul übertragen.

Bei einer weiteren Ausführungsform weist das optische Modul ein Vakuum-Gehäusebauteil zur vakuumdichten Befestigung des optischen Moduls an dem Vakuum-Gehäuse auf. Wenn das optische Modul sich in der Entnahmeposition (oder ggf. der Lagerungsposition) befindet, kann das Vakuum-Gehäusebauteil, z.B. in Form einer Abdeckplatte, an dem Vakuum-Gehäuse montiert werden, so dass das Vakuum-Gehäuse vakuumdicht abgeschlossen ist und zum Betrieb der optischen Anordnung evakuiert werden kann.

Bevorzugt ist das Vakuum-Gehäusebauteil über ein elastisches Vakuum-Bauelement an den ersten Trägerkörper angebunden. Als elastisches Vakuum-Bauelement kann beispielsweise ein gewellter metallischer Faltenbalg (Wellbalg) dienen. Durch die elastische Anbindung kann der Trägerkörper des optischen Moduls vom Vakuum-Gehäuse entkoppelt werden, so dass die auf das Vakuum-Bauelement ausgeübten, durch das Vakuum erzeugten Kräfte nicht auf den Trägerkörper bzw. auf die mit diesem verbundenen optischen Elemente übertragen werden. An dem Trägerkörper kann eine Öffnung zur Zuführung von Strahlung zu den optischen Elementen des optischen Moduls vorgesehen sein, die beispielsweise von einer außerhalb des Vakuum-Gehäuses angeordneten Strahlquelle, insbesondere einer Laser-Quelle, erzeugt wird. Bei der Verschiebebewegung des Trägerkörpers wird die Öffnung relativ zu dem Vakuum-Bauelement verschoben, welches starr mit dem Vakuum-Gehäuse verbunden ist.

Bei einer weiteren Ausführungsform weisen die ersten Lagerungselemente mindestens eine plane Lagerfläche und die zweiten Lagerungselemente mindestens eine gekrümmte Lagerfläche auf, oder umgekehrt. Das erste Lagerungselement weist bevorzugt eine Ausnehmung für den Eingriff von Lagerflächen des zweiten Lagerungselements auf. Die Ausnehmung kann in der Art eines umgekehrten Kegelstumpfs ausgebildet sein, dessen Mantelfläche in Umfangsrichtung mehrere plane Lagerflächen aufweist, die ggf. eine Fase bilden. Die Grundfläche des Kegelstumpfs ist hierbei polygonal, z.B. quadratisch ausgebildet. Durch die kegelstumpfartige Geometrie der Ausnehmung des ersten Lagerungselements kann beim Eingriff des zweiten Lagerungselements in die Ausnehmung des ersten Lagerungselements eine Selbst-Zentrierung erfolgen. Die zweiten, ortsfesten Lagerungselemente weisen mindestens eine gekrümmte, bevorzugt ballig gekrümmte, insbesondere sphärisch oder ellipsoid gekrümmte Lagerfläche auf. Bei der Bewegung der ersten Lagerungselemente in Bewegungsrichtung kann die gekrümmte Lagerfläche an einer jeweiligen planen Lagerfläche entlang gleiten, bis die Lagerungsposition erreicht ist, in welcher die Lagerflächen ortsfest zueinander angeordnet sind und aneinander angedrückt werden. Durch die Lagerung der gekrümmten Fläche an den planen Flächen der prismatischen Ausnehmung ist die Position des Trägerkörpers statisch bestimmt und das optische Modul somit reproduzierbar an dem ortsfesten Trägerkörper gelagert. Zur Realisierung der Lagerung ist grundsätzlich jegliche Art statisch bestimmter, bzw. statisch überbestimmter Lagerung möglich. Insbesondere sind beispielsweise auch gekrümmte Lagerflächen am ersten Lagerungselement und plane Lagerflächen am zweiten Lagerungselement möglich.

Bei einer weiteren Ausführungsform weist die Verschiebeeinrichtung mindestens eine, bevorzugt eine Mehrzahl von Hubeinrichtungen zum Andrücken jeweils eines ersten Lagerungselements gegen ein diesem zugeordnetes zweites Lagerungselement auf. Die Hubeinrichtungen greifen bevorzugt an der Unterseite des ersten Trägerkörpers, insbesondere an der Unterseite des Trägerschlittens an, um diesen von der Entnahmeposition in die Lagerungsposition anzuheben. Für das Andrücken der ersten Lagerungselemente gegen die zweiten Lagerungselemente ist es günstig, wenn die Hubeinrichtungen und die zweiten Lagerungselemente entlang einer gemeinsamen, in Bewegungsrichtung verlaufenden Achse (Hubachse) angeordnet sind. Beispielsweise können bei einer vertikalen Bewegungsrichtung bzw. Hubachse die Hubeinrichtungen in der Entnahmeposition jeweils unterhalb der zweiten Lagerungselemente positioniert sein. Die Hubeinrichtungen greifen typischer Weise über linear verschiebbare Hubelemente an der Unterseite des Trägerkörpers, genauer gesagt des Trägerschlittens an. Die verschiebbaren Hubelemente können mit dem Vakuum-Gehäuse über elastische Vakuum-Bauelemente z.B. in Form von Faltenbälgen verbunden sein. Auf diese Weise kann der Innenraum des Hubelements hermetisch von der Vakuum-Umgebung im Innenraum des Vakuum-Gehäuses abgetrennt werden. Es versteht sich, dass gegebenenfalls zum Anheben des Trägerkörpers auch eine einzige Hubeinrichtung mit einem flächigen Hubelement vorgesehen werden kann, welches alle drei (oder mehr) Lagerungselemente des optischen Moduls gegen die entsprechenden ortsfesten Lagerungselemente andrückt.

Bei einer weiteren Ausführungsform weist mindestens eine Hubeinrichtung mindestens ein vorgespanntes Federelement auf. Die Vorspannung kann sowohl zur Realisierung der Hubbewegung beim Verbringen des ersten Trägerkörpers von der Entnahmeposition in die Lagerungsposition als auch zum Aufbringen der Andruckkraft in der Lagerungsposition genutzt werden. Auf diese Weise ist zum Halten bzw. zum Andrücken der ersten Lagerungselemente gegen die zweiten Lagerungselemente während des Betriebs der optischen Anordnung keine Zufuhr von Energie erforderlich. Zum Verbringen des Trägerkörpers in die Entnahmeposition wird mittels eines Aktuators eine die Vorspannung der Federelemente überwindende Fremdenergie aufgebracht, welche eine Verschiebung eines entlang der Bewegungsrichtung verschiebbaren Hubelements der Hubeinrichtung entgegen der Kraftwirkung der Federelemente bewirkt.

In einer Weiterbildung weist mindestens eine Hubeinrichtung einen Druckraum auf, der zum Erzeugen einer der Vorspannung des mindestens einen Federelements entgegen gesetzten Kraft mit einem Druckmedium (einem Druckfluid) beaufschlagbar ist. Durch das Erzeugen eines Fluiddrucks z.B. unter Verwendung eines Druckgases oder einer Druckflüssigkeit kann die Vorspannung überwunden und die Federelemente können weiter zusammengedrückt werden, bis die Lagerungselemente nicht mehr miteinander im Eingriff stehen. Die Federelemente können insbesondere als Tellerfedern ausgebildet werden, auf deren Federteller direkt ein Fluiddruck aufgebracht werden kann, um diese zusammenzudrücken. Bevorzugt wird der Trägerschlitten durch das Druckfluid so weit abgesenkt, dass die Rollen bzw. Räder und/oder Gleitelemente in der Entnahmeposition auf der Auflagefläche aufliegen, so dass das optische Modul auf einfache Weise aus dem Gehäuse hinaus bewegt werden kann.

Bevorzugt ist das mindestens eine optische Element des optischen Moduls zur Reflexion von Laserstrahlung ausgebildet. Das optische Modul kann insbesondere zur Strahlführung eines Laserstrahls, insbesondere eines CO₂-Laserstrahls, ausgelegt sein. Wie weiter oben dargestellt wurde, können optische Elemente, welche CO₂-Laserstrahlung reflektieren, in der Nähe einer Zielposition angeordnet werden, an denen ein Target-Material verdampft wird, da die Verschmutzung von deren optischen Oberflächen durch das Target-Material einen vergleichsweise geringen Einfluss auf deren Reflektivität hat. Optische Elemente zur Reflexion von (CO₂)-Laserstrahlung können ein metallisches Substrat, z.B. aus Kupfer, aufweisen, welches selbst als reflektierende Oberfläche dienen kann. Auf das metallische Substrat kann eine reflektierende Beschichtung aufgebracht werden, um die Reflektivität für die Laserstrahlung weiter zu erhöhen.

Es versteht sich, dass optische Elemente, die an dem ersten bzw. an dem zweiten Trägerkörper angebracht sind, nicht zwingend als reflektierende optische Elemente ausgebildet sein müssen, sondern ggf. auch als transmittierende optische Elemente ausgebildet sein können. Insbesondere ist dies der Fall, wenn die optischen Elemente zur Transmission bzw. Reflexion von Strahlung in anderen Wellenlängenbereichen als dem EUV-Wellenlängenbereich (d.h. bei Wellenlängen zwischen ca. 5 nm und ca. 50 nm) oder dem IR-Wellenlängenbereich (z.B. bei 10,6 µm) ausgebildet sind. Es ist auch möglich, im IR-Wellenlängenbereich transmittierende optische Elemente an dem optischen Modul vorzusehen, beispielsweise optische Elemente aus Zinkselenid.

Die Erfindung betrifft auch ein optisches Modul für eine optische Anordnung wie oben beschrieben, umfassend: einen Trägerkörper, an dem mindestens ein insbesondere reflektierendes optisches Element zur Strahlführung eines Laserstrahls und eine Mehrzahl von ersten Lagerungselementen angebracht sind, wobei der Trägerkörper zur Entnahme des optischen Moduls aus einem Gehäuse, insbesondere aus einem Vakuum-Gehäuse, einen Trägerschlitten mit einer Mehrzahl von Rollen und/oder Gleitelementen aufweist. Durch die Verwendung des Trägerschlittens bzw. der Rollen/Gleitelemente kann das Verschieben des optischen Moduls von der/an die Entnahmeposition vereinfacht werden. Die optischen Elemente sind typischer Weise starr mit dem Trägerkörper verbunden, so dass durch eine definierte Lagerung des Trägerkörpers auch die optischen Elemente an einer definierten Position angeordnet werden können.

Bei einer weiteren Ausführungsform umfasst das optische Modul ein Vakuum-Gehäusebauteil zur vakuumdichten Befestigung des optischen Moduls an dem Vakuum-Gehäuse. Das Vakuum-Gehäusebauteil kann beispielsweise plattenförmig ausgebildet sein und wird typischer Weise an seinem umlaufenden Rand dichtend an dem Vakuum-Gehäuse befestigt. In einer vorteilhaften Weiterbildung ist das Vakuum-Gehäusebauteil an dem Trägerkörper über ein elastisches Vakuum-Bauelement, z.B. einen Faltenbalg, angebunden. Auf diese Weise kann das Vakuum-Gehäusebauteil relativ zum Trägerkörper verschoben werden, um den Trägerkörper im Einbauzustand zwischen der Entnahmeposition und der Lagerungsposition zu verschieben.

Die Erfindung betrifft auch ein Verfahren zum lagerichtigen Positionieren eines optischen Moduls in einem Gehäuse einer optischen Anordnung wie oben beschrieben, umfassend die Schritte: Bewegen des Trägerkörpers des optischen Moduls von einer Bereitstellungsposition an eine Entnahmeposition in dem Gehäuse, sowie Bewegen des Trägerkörpers des optischen Moduls von der Entnahmeposition in die Lagerungsposition, in der die ersten Lagerungselemente gegen die zweiten Lagerungselemente angedrückt werden. Typischer Weise wird nach dem Bewegen des optischen Moduls bzw. des Trägerkörpers von der Bereitstellungsposition in die Entnahmeposition bzw. die Lagerungsposition das Vakuum-Gehäusebauteil mit dem Vakuum-Gehäuse verbunden, um das Vakuum-Gehäuse für den Betrieb der optischen Anordnung evakuieren zu können.

Bei einer Variante des Verfahrens wird zum Bewegen des Trägerkörpers von der Bereitstellungsposition in die Entnahmeposition der Trägerschlitten des optischen Moduls entlang einer Auflagefläche des Gehäuses (bevorzugt rollend und/oder gleitend) verschoben. Um die Verschiebung entlang der Auflagefläche zu vereinfachen, kann wie oben dargestellt der Trägerkörper einen mit Rollen und/oder Gleitelementen versehenen Trägerschlitten aufweisen.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine schematische Darstellung eines optischen Moduls zur Verwendung in einem Vakuum-Gehäuse einer optischen Anordnung in Form eines Strahlerzeugungssystems einer EUV-Lithographieanlage,
- Fig. 2: eine schematische Darstellung des optischen Moduls von Fig. 1 im Einbauzustand in dem Vakuum-Gehäuse,
- Fig. 3a,b: einen Gehäuseabschnitt des Vakuum-Gehäuses mit einem Trägerschlitten des optischen Moduls in einer vom Vakuum-Gehäuse beabstandeten Bereitstellungsposition sowie in einer Entnahmeposition,
- Fig. 4a: einen Abschnitt des Vakuum-Gehäuses mit drei Hubeinrichtungen zum Anheben des Trägerkörpers des optischen Moduls in eine Lagerungsposition,
- Fig. 4b: einen Trägerkörper für einen Kollektor-Spiegel mit drei Lagerungselementen, die in der Lagerungsposition mit drei Lagerungselementen des optischen Moduls in Eingriff gebracht werden, sowie
- Fig. 5a,b: eine Hubeinrichtung mit dem Trägerschlitten des optischen Moduls in der Lagerungsposition (Fig. 5a) bzw. in der Entnahmeposition (Fig. 5b).

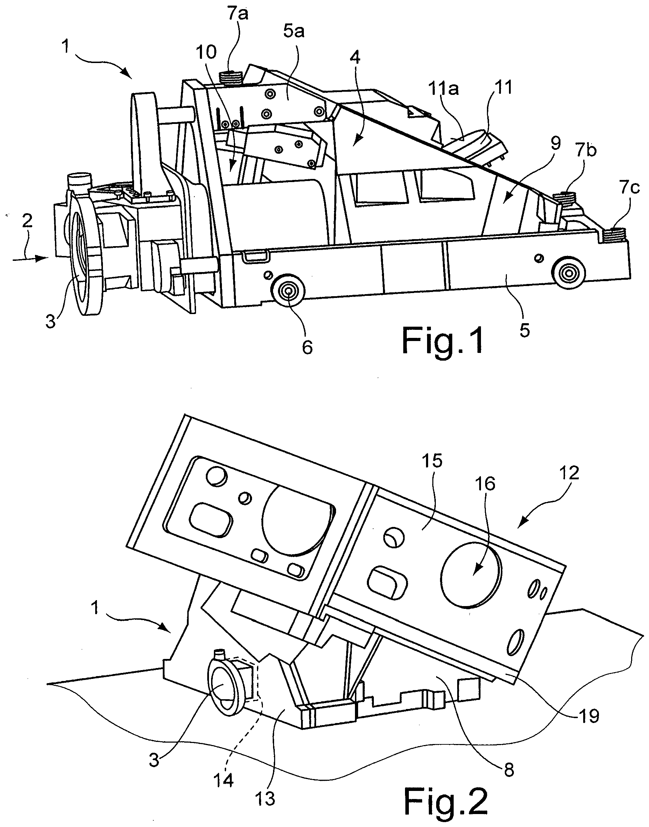

Fig. 1 zeigt ein optisches Modul 1 zur Strahlführung eines CO₂-Laserstrahls 2, welcher an einer Strahleintrittsöffnung 3 in das optische Modul 1 eintritt. Das optische Modul 1 weist einen starren Trägerkörper 4 auf, der einen Trägerschlitten 5 sowie ein Tragelement 5a (Trägerrahmen) umfasst. An dem Trägerschlitten 5 sind im vorliegenden Beispiel vier Rollen 6 angebracht, um eine rollende Bewegung des optischen Moduls 1 entlang einer typischer Weise horizontalen Bewegungsrichtung zu ermöglichen. Auch die Anbringung von Gleitelementen, z.B. von Kufen, an dem Trägerschlitten 5 ist möglich. An dem Trägerkörper 4, genauer gesagt an dem Trägerschlitten 5, sind auch drei Lagerungselemente 7a-c angebracht, um das optische Modul 1 lagerichtig in einem in Fig. 2 gezeigten Gehäuse 8 zu positionieren.

Für die Strahlführung des Laserstrahls 2 weist das optische Modul 1 drei optische Elemente 9, 10, 11 auf, von denen das erste und das zweite optische Element 9, 10 bei der in Fig. 1 gezeigten Darstellung durch den Trägerkörper 4 verdeckt sind. Das erste und zweite optische Element 9, 10 dienen der Fokussierung des Laserstrahls 2 an einer nicht näher gezeigten Zielposition, an der ein Target-Material, im vorliegenden Fall Zinn, bereitgestellt wird, welches bei der Bestrahlung mit dem Laserstrahl 2 in einen Plasma-Zustand übergeht und hierbei EUV-Strahlung emittiert. Das dritte optische Element ist ein Planspiegel 11 zur Umlenkung des fokussierten Laserstrahls 2 in Richtung auf die Zielposition. Bei der Bestrahlung mit dem Laserstrahl 2 wird ein Teil des Target-Materials verdampft, der sich auf den optischen Oberflächen der in der Nähe der Zielposition angeordneten optischen Elemente 9, 10, 11 ablagern kann. Beispielsweise kann dies bei der optischen Oberfläche 11a des in Fig. 1 gezeigten Planspiegels 11 der Fall sein, der von den drei optischen Elementen 9, 10, 11 den geringsten Abstand zur Zielposition aufweist.

Fig. 2 zeigt das optische Modul 1 in einem Einbauzustand in einem Gehäuse 8 einer optischen Anordnung 12 in Form eines Strahlerzeugungssystems zur Erzeugung von EUV-Strahlung. Die in der optischen Anordnung 12 erzeugte EUV-Strahlung wird einem (nicht gezeigten) Beleuchtungssystem zugeführt, um ein Bildfeld, an dem ein strukturtragendes Element (Maske) angeordnet ist, möglichst homogen auszuleuchten. Ein (ebenfalls nicht gezeigtes) Projektionssystem dient der Abbildung der Struktur der Maske auf ein lichtempfindliches Substrat (Wafer). Das Strahlerzeugungssystem 12, das Beleuchtungssystem und das Projektionssystem bilden zusammen eine EUV-Lithographieanlage zur Strukturierung des lichtempfindlichen Substrats (Wafer).

Um die Absorption der erzeugten EUV-Strahlung durch gasförmige Stoffe möglichst gering zu halten, ist das Gehäuse 8 als Vakuum-Gehäuse ausgebildet und kann mit Hilfe einer (nicht gezeigten) Pumpeinrichtung evakuiert werden. Um das Vakuum-Gehäuse 8 mit dem eingesetzten Modul 1 vakuumdicht zu verschließen, ist an dem optischen Modul 1 ein Vakuum-Gehäusebauteil in Form einer Abdeckplatte 13 (in Fig. 1 nicht gezeigt, vgl. Fig. 2) angebracht, welche mit dem Vakuum-Gehäuse 8 vakuumdicht verbunden wird. Für die vakuumdichte Verbindung der Abdeckplatte 13 mit dem Vakuum-Gehäuse 8 dienen nicht gezeigte Schraubverbindungen sowie entsprechende Dichtungen, welche entlang des äußeren Randes der Abdeckplatte 13 verlaufen.

Die Abdeckplatte 13 ist hierbei mit dem Trägerkörper 4 über einen in Fig. 2 angedeuteten metallischen Faltenbalg 14 verbunden, der als elastisches Vakuum-Gehäusebauteil dient und der eine Bewegung des Trägerkörpers 4 relativ zum Vakuum-Gehäuse 8 auch nach der Fixierung der Abdeckplatte 13 ermöglicht. Eine solche Bewegung ist erforderlich, um das in das Vakuum-Gehäuse 8 integrierte optische Modul 1 aus einer Entnahmeposition in eine Lagerungsposition zu verbringen, wie weiter unten näher ausgeführt wird. In Fig. 2 ebenfalls gezeigt ist eine Prozesskammer 15, in der ein in Fig. 2 durch einen Pfeil angedeuteter Kollektor-Spiegel 16 untergebracht ist, um die von der Zielposition ausgehende EUV-Strahlung aufzufangen.

Um die optischen Oberflächen der optischen Elemente 9, 10, 11 zu reinigen oder um ggf. eines oder mehrere der optischen Elemente 9, 10, 11 auszutauschen, kann das optische Modul 1 aus dem Gehäuse 8 entnommen werden, indem die Verbindung der Abdeckplatte 13 mit dem Vakuum-Gehäuse 8 gelöst wird und das optische Modul 1 aus dem Vakuum-Gehäuse 8 entnommen wird.

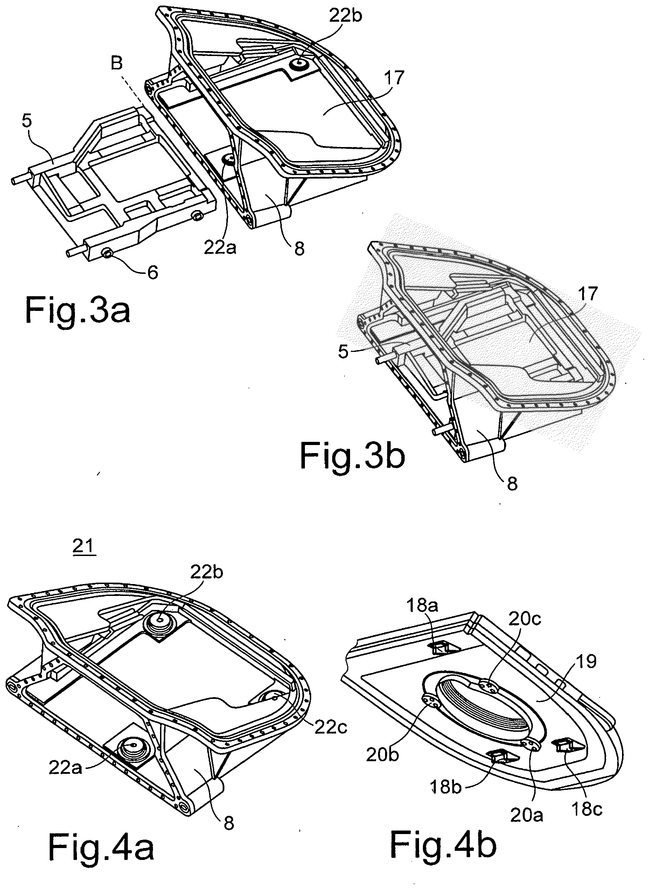

Für die Entnahme und für die erneute Positionierung des optischen Moduls 1 in dem Vakuum-Gehäuse 8 kann das optische Modul 1 entlang einer an dem Vakuum-Gehäuse 8 vorgesehenen planen, horizontalen Auflagefläche 17 entlang verschoben werden, welche in **Fig. 3a,b** dargestellt ist. Fig. 3a zeigt hierbei zur Vereinfachung nur den Trägerschlitten 5 mit den Rollen 6 in einer Bereitstellungsposition **B,** das heißt einer vom Gehäuse 8 beabstandeten Position, an der die Wartung durchgeführt werden kann, während Fig. 3b den in das Gehäuse 8 eingeschobenen Trägerschlitten 5 in einer Position zeigt, in der dieser mittels der Abdeckplatte 13 in das Vakuum-Gehäuse 8, genauer gesagt in einen keilförmigen Abschnitt desselben integriert werden kann.

Um den Trägerschlitten 5 von der in Fig. 3a gezeigten Position in die in Fig. 3b gezeigte Position (und zurück) zu verschieben, können (nicht gezeigte) Hilfsflächen vorgesehen werden, die eine möglichst horizontale Bewegung des Trägerschlittens 5 bzw. des optischen Moduls 1 ermöglichen. Als Hilfsfläche kann beispielsweise eine plane Auflageplatte vorgesehen werden, deren Oberseite bündig mit der Auflagefläche 17 des Vakuum-Gehäuses 8 abschließt. Auch können zusätzliche Stützrollen an dem Trägerschlitten 5 angebracht werden, um dessen Gewicht aufzunehmen. Auch können Führungsschienen verwendet werden, um die Verschiebung des optischen Moduls 1 zu vereinfachen.

Bei der in Fig. 3b gezeigten Stellung des Trägerschlittens 5 befinden sich die Lagerungselemente 7a-c in vertikaler Richtung unterhalb von Lagerungselementen 18a-c, die an einer in **Fig. 4b** dargestellten Trägerplatte 19 angebracht sind, welche als Trägerkörper für den Kollektor-Spiegel 16 dient. An der Trägerplatte 19 sind am Rand einer Durchtrittsöffnung für die Laserstrahlung und in der Nähe der Lagerungselemente 18a-c drei Lagerungspunkte 20a-c zur Halterung des Kollektor-Spiegels 16 angebracht. Durch die relative Nähe der Lagerungspunkte 20a-c zu den Lagerungselementen 18a-c für das optische Modul 1 wird die dynamische und statische Steifigkeit verbessert.

Die Oberseite des in **Fig. 4a** gezeigten Abschnitts des Vakuum-Gehäuses 8 ist an der in Fig. 4b gezeigten Trägerplatte 19 befestigt und mit dieser fest verbunden. Die Trägerplatte 19 und damit die an dieser angebrachten Lagerungselemente 18a-c, 20a-c sind ein ortsfester Bestandteil des Strahlformungssystems 12, bezüglich dessen die optischen Elemente 9, 10, 11 bei der Integration in das Strahlformungssystem 12 lagerichtig positioniert werden müssen.

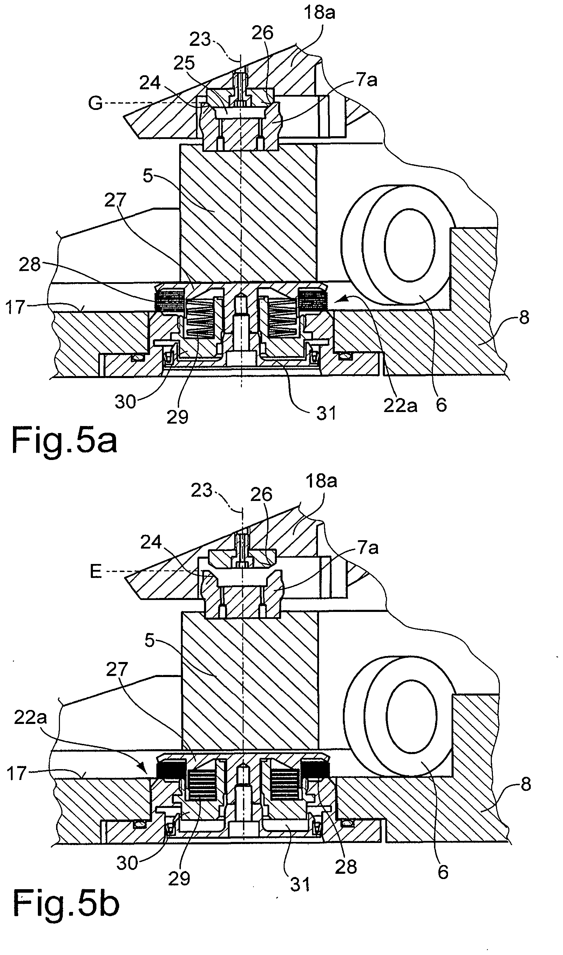

Um das optische Modul 1, genauer gesagt die optischen Elemente 9, 10, 11, lagerichtig relativ zur Trägerplatte 19 (und damit zum Kollektor-Spiegel 16) auszurichten, ist an dem Strahlformungssystem 12 eine Bewegungseinrichtung 21 vorgesehen, welche drei Hubeinrichtungen 22a-c aufweist, um den Trägerkörper 4 des optischen Moduls 1 zwischen einer Lagerungsposition **G,** welche in **Fig. 5a** dargestellt ist, und einer Entnahmeposition **E,** welche in **Fig. 5b** dargestellt ist, entlang einer in vertikaler Richtung verlaufenden Hubachse 23 hin und her zu bewegen. In der in Fig. 5b dargestellten Entnahmeposition E kann das optische Modul 1 auf die weiter oben beschriebene Weise aus dem Vakuum-Gehäuse 8 entfernt werden.

In der in Fig. 5a gezeigten Lagerungsposition G werden die drei Lagerungselemente 7a-c des optischen Moduls 1 gegen die Wirkung der Schwerkraft gegen ein jeweils zugeordnetes Lagerungselement 18a-c der in Fig. 5a nicht dargestellten Trägerplatte 19 angedrückt, wie in Fig. 5a anhand eines ersten Paars 7a, 18a von Lagerungselementen dargestellt ist. Um eine hohe Präzision bei der Lagerung zu gewährleisten, weisen die ersten Lagerungselemente 7a-c jeweils zwei plane Lagerflächen 24 auf, welche den Rand bzw. die Fase einer Ausnehmung 25 bilden, die in der Art eines (invertierten) Kegelstumpfs mit quadratischer Grundfläche (prismatisch) ausgebildet ist. An den Lagerungselementen 18a-c der Trägerplatte 19 ist eine umlaufende, sphärisch gekrümmte Lagerfläche 26 gebildet. In der Lagerungsposition G liegen die planen Lagerflächen 24 der Lagerungselemente 7a-c des optischen Moduls 1 an der sphärischen Lagerfläche 26 der Lagerungselemente 18a-c der Trägerplatte 19 an. In der Lagerungsposition G werden die Lagerflächen 24 der Lagerungselemente 7a-c des optischen Moduls 1 mit Hilfe der Hubeinrichtungen 22a-c gegen die Lagerungselemente 18a-c der Trägerplatte 19 angedrückt. Um das Andrücken zu bewerkstelligen, wird ein Hubelement 27 der jeweiligen Hubeinrichtung 22a-c gegen die Unterseite des Trägerschlittens 5 angedrückt.

Die durch die sphärische Lagerfläche 26 und die prismatische Anordnung der planen Lagerflächen 24 erreichte Genauigkeit der Lagerung des Trägerkörpers 4 liegt im Mikrometerbereich. Eine solche Genauigkeit ist ausreichend, um bei der Ausrichtung der optischen Elemente 9, 10, 11 des optischen Moduls 1 gegenüber den ortsfesten optischen Elementen, insbesondere gegenüber dem Kollektor-Spiegel 16, auf eine zusätzliche Justage der Trägerkörpers 4 bzw. des Trägerschlittens 5 relativ zur Trägerplatte 19 verzichten zu können.

Wie in Fig. 5a ebenfalls zu erkennen ist, sind in der Lagerungsposition G die Rollen bzw. Räder 6 des Trägerschlittens 5 von der Auflagefläche 17 abgehoben. Das entlang der Hubachse 23 verschiebbare Hubelement 27 der jeweiligen Hubeinrichtung 22a-c, welches gegen die Unterseite des Trägerschlittens 5 drückt, ist an dem Vakuum-Gehäuse 8 über ein elastisches Vakuum-Bauelement 28 angebunden, welches ebenfalls als Faltenbalg ausgebildet ist. Das elastische Vakuum-Bauelement dient als Vakuumabdichtung gegenüber der Umgebung.

Um den Trägerschlitten 5 in der in Fig. 5a gezeigten Lagerungsposition G zu halten, ist in den Hubeinrichtungen 22a-c zwischen einem ortsfesten Grundkörper 30 und dem Hubelement 27 eine vorgespannte Tellerfeder 29 vorgesehen. Um das Hubelement 27 (und damit den Trägerschlitten 5) von der in Fig. 5a gezeigten Lagerungsposition G in die in Fig. 5b gezeigte Entnahmeposition E zu verbringen, in welcher die Rollen 6 des Trägerschlittens 5 auf der Auflagefläche 17 aufliegen, wird ein Aktuator verwendet, welcher Teil der Bewegungseinrichtung 21 ist.

Zur Verschiebung des Hubelements 27 nach unten wird in einen in den Hubeinrichtungen 22a-c gebildeten Druckraum 31 ein Druckmedium, im vorliegenden Beispiel Druckluft, eingebracht. Das Druckmedium übt auf die Oberseite der Tellerfeder 29 eine Kraft aus, welche groß genug ist, um diese so weit zusammenzudrücken, dass zwischen der Unterseite des Trägerschlittens 5 und dem Hubelement 27 ein Spalt gebildet wird, so dass dieser nicht mehr von der Hubeinrichtung 22a-c unterstützt wird und die Rollen 6 auf der Auflagefläche 17 aufliegen. Entsprechend greifen in der Entnahmeposition E auch die Lagerungselemente 7a-c, 18a-c nicht mehr ineinander ein, so dass das optische Modul 1 entlang der Auflagefläche 17 aus dem Vakuum-Gehäuse 8 heraus gerollt werden kann.

Beim Absenken des Trägerkörpers 4 werden typischer Weise die Druckräume 31 der drei Hubeinrichtungen 22a-c nacheinander mit einem Druckmedium beaufschlagt. Dies ist möglich, da der Bewegungsweg entlang der Hubachse 23 in der Regel im Bereich von wenigen Millimetern liegt, so dass ein Verkeilen des optischen Moduls 1 in dem Vakuum-Gehäuse 8 bei einer hierdurch bewirkten Schrägstellung nicht zu befürchten ist. Es versteht sich, dass ggf. auch alle drei Druckräume 31 der Hubeinrichtungen 22a-c gleichzeitig (gesteuert) mit einem Druckmedium beaufschlagt werden können, um ein synchrones Absenken der Hubelemente 27 der drei Hubeinrichtungen 22a-c und damit ein Absenken des Trägerschlittens 5 parallel zur Auflagefläche 17 zu bewirken. Das Druckmedium wird dem Druckraum 31 über eine radiale Bohrung zugeführt.

Das optische Modul 1 kann in der Entnahmeposition E trotz des geringen zur Verfügung stehenden Bauraumes auf einfache Weise für Wartungsarbeiten aus dem Vakuum-Gehäuse 8 entnommen werden, beispielsweise um eines der optischen Elemente 9, 10, 11 gegen ein anderes auszutauschen. In der Lagerungsposition G wird eine reproduzierbare Lagerung bzw. Ausrichtung der optischen Elemente 9, 10, 11 ermöglicht, ohne dass zu diesem Zweck eine zusätzliche Justage erforderlich wäre.

## Patentansprüche

1. Optische Anordnung (12), umfassend:
ein optisches Modul (1) mit einem ersten Trägerkörper (4), an dem mindestens ein insbesondere reflektierendes optisches Element (9, 10, 11) zur Strahlführung eines Laserstrahls (2) und eine Mehrzahl von ersten Lagerungselementen (7a-c) angebracht ist,
ein Gehäuse (8), insbesondere ein Vakuum-Gehäuse, mit einem zweiten Trägerkörper (19) für mindestens ein weiteres optisches Element (16), welches zur Reflexion von EUV-Strahlung ausgebildet ist, wobei an dem zweiten Trägerkörper (19) eine Mehrzahl von zweiten Lagerungselementen (18a-c) angebracht ist, sowie
eine Bewegungseinrichtung (21) zur Verschiebung des ersten Trägerkörpers (4) relativ zum zweiten Trägerkörper (19) in einer insbesondere vertikalen Bewegungsrichtung (23) zwischen einer Entnahmeposition (E), von der aus das optische Modul (1) aus dem Gehäuse (8) entnehmbar ist und einer Lagerungsposition (G), in der die Bewegungseinrichtung (21) die ersten Lagerungselemente (7a-c) gegen die zweiten Lagerungselemente (18a-c) andrückt.

2. Optische Anordnung nach Anspruch 1, bei welcher der erste Trägerkörper (4) einen Trägerschlitten (5) umfasst, der mit einer Mehrzahl von Rollen (6) und/oder Gleitelementen versehen ist.

3. Optische Anordnung nach Anspruch 2, bei welcher die Rollen (6) und/oder die Gleitelemente in der Entnahmeposition (E) auf einer Auflagefläche (17) am Gehäuse (8) aufliegen und in der Lagerungsposition (G) zur Auflagefiäche (17) beabstandet sind.

4. Optische Anordnung nach einem der vorhergehenden Ansprüche, bei welcher das optische Modul (1) ein Vakuum-Gehäusebauteil (13) zur vakuumdichten Befestigung des optischen Moduls (1) an dem Vakuum-Gehäuse (8) aufweist

5. Optische Anordnung nach Anspruch 4, bei welcher das Vakuum-Gehäusebauteil (13) über ein elastisches Vakuum-Bauelement (14) an den ersten Trägerkörper (4) angebunden ist.

6. Optische Anordnung nach einem der vorhergehenden Ansprüche, bei welcher die ersten Lagerungselemente (7a-c) mindestens eine plane Lagerfläche (24) und die zweiten Lagerungselemente (18a-c) mindestens eine gekrümmte Lagerfläche (26) aufweisen oder umgekehrt.

7. Optische Anordnung nach einem der vorhergehenden Ansprüche, bei welcher die Bewegungseinrichtung (21) mindestens eine, bevorzugt eine Mehrzahl von Hubeinrichtungen (22a-c) zum Andrücken jeweils eines ersten Lagerungselementes (7a-c) gegen ein diesem zugeordnetes zweites Lagerungselement (18a-c) umfasst.

8. Optische Anordnung nach Anspruch 7, bei welcher mindestens eine Hubeinrichtung (22a-c) mindestens ein vorgespanntes Federelement (29) aufweist.

9. Optische Anordnung nach Anspruch 8, bei welcher mindestens eine Hubeinrichtung (22a-c) einen Druckraum (31) aufweist, der zum Erzeugen einer der Vorspannung des mindestens einen Federelements (29) entgegen gesetzten Kraft mit einem Druckmedium beaufschlagbar ist.

10. Optische Anordnung nach einem der vorhergehenden Ansprüche, bei weicher das mindestens eine optische Element (9, 10, 11) des optischen Moduls (1) zur Reflexion von Laserstrahlung ausgebildet ist.

11. Optisches Modul (1) für eine optische Anordnung (12) nach einem der vorhergehenden Ansprüche, umfassend:
einen Trägerkörper (4), an dem mindestens ein insbesondere reflektierendes optisches Element (9, 10, 11) zur Strahlführung eines Laserstrahls (2) und eine Mehrzahl von ersten Lagerungselementen (7a-c) angebracht sind, wobei der Trägerkörper (4) zur Entnahme des optischen Moduls (1) aus einem Gehäuse (8), insbesondere aus einem Vakuum-Gehäuse, einen Trägerschlitten (5) mit einer Mehrzahl von Rollen (6) und/oder Gleitelementen aufweist.

12. Optisches Modul nach Anspruch 11, weiter umfassend: ein Vakuum-Gehäusebauteil (13), welches an dem Trägerkörper (4) über ein elastisches Vakuum-Bauelement (14) angebunden ist.

13. Verfahren zum lagerichtigen Positionieren eines optischen Moduls (1) in einem Gehäuse (8) einer optischen Anordnung (12) nach einem der Ansprüche 1 bis 10, umfassend die Schritte:
Bewegen des Trägerkörpers (4) des optischen Moduls (1) von einer Bereitstellungsposition (B) an eine Entnahmeposition (E) in dem Gehäuse (8), sowie
Bewegen des Trägerkörpers (4) des optischen Moduls (1) von der Entnahmeposition (E) in die Lagerungsposition (G), in der die ersten Lagerungselemente (7a-c) gegen die zweiten Lagerungselemente (18a-c) angedrückt werden.

14. Verfahren nach Anspruch 13, bei dem zum Bewegen des Trägerkörpers (4) von der Bereitstellungsposition (B) in die Entnahmeposition (E) der Trägerschlitten (5) des optischen Moduls (1) entlang einer Auflagefläche (17) des Gehäuses (8) verschoben wird.

## Claims

1. Optical arrangement (12) comprising:
an optical module (1) having a first carrier body (4) to which there are attached at least one, in particular reflective, optical element (9, 10, 11) for the beam guidance of a laser beam (2), and a plurality of first mounting elements (7a-c),
a housing (8), in particular a vacuum housing, having a second carrier body (19) for at least one further optical element (16) which is configured for the reflection of EUV radiation, wherein a plurality of second mounting elements (18a-c) is attached to the second carrier body (19), and also
a movement device (21) for displacing the first carrier body (4) relative to the second carrier body (19) in a movement direction (23), in particular a vertical movement direction, between a removal position (E), from which the optical module (1) can be removed from the housing (8), and a mounting position (G), in which the movement device (21) presses the first mounting elements (7a-c) against the second mounting elements (18a-c).

2. Optical arrangement according to claim 1, wherein the first carrier body (4) comprises a carrier slide (5) which is provided with a plurality of rollers (6) and/or sliding elements.

3. Optical arrangement according to claim 2, wherein the rollers (6) and/or the sliding elements rest on a support surface (17) on the housing (8) in the removal position (E) and are at a distance from the support surface (17) in the mounting position (G).

4. Optical arrangement according to any one of the preceding claims, wherein the optical module (1) has a vacuum housing component (13) for the vacuum-tight fastening of the optical module (1) to the vacuum housing (8).

5. Optical arrangement according to claim 4, wherein the vacuum housing component (13) is attached to the first carrier body (4) by way of a flexible vacuum element (14).

6. Optical arrangement according to any one of the preceding claims, wherein the first mounting elements (7a-c) have at least one planar bearing surface (24) and the second mounting elements (18a-c) have at least one curved bearing surface (26), or *vice versa.*

7. Optical arrangement according to any one of the preceding claims, wherein the movement device (21) comprises at least one, preferably a plurality of, lifting device(s) (22a-c) for pressing in each case a first mounting element (7a-c) against a second mounting element (18a-c) associated therewith.

8. Optical arrangement according to claim 7, wherein at least one lifting device (22a-c) has at least one biased spring element (29).

9. Optical arrangement according to claim 8, wherein at least one lifting device (22a-c) has a pressure chamber (31) to which a pressure medium can be applied in order to generate a force that opposes the bias of the at least one spring element (29).

10. Optical arrangement according to any one of the preceding claims, wherein the at least one optical element (9, 10, 11) of the optical module (1) is configured for the reflection of laser radiation.

11. Optical module (1) for an optical arrangement (12) according to any one of the preceding claims, comprising:
a carrier body (4) to which there are attached at least one, in particular reflective, optical element (9, 10, 11) for the guidance of a laser beam (2) and a plurality of first mounting elements (7a-c), wherein the carrier body (4) has a carrier slide (5) having a plurality of rollers (6) and/or sliding elements for the removal of the optical module (1) from a housing (8), in particular from a vacuum housing.

12. Optical module according to claim 11, further comprising: a vacuum housing component (13) which is attached to the carrier body (4) by way of a flexible vacuum element (14).

13. Method for correctly positioning an optical module (1) in a housing (8) of an optical arrangement (12) according to any one of claims 1 to 10, which method comprises the following steps:
moving the carrier body (4) of the optical module (1) from an access position (B) to a removal position (E) in the housing (8), and
moving the carrier body (4) of the optical module (1) from the removal position (E) into the mounting position (G), in which the first mounting elements (7a-c) are pressed against the second mounting elements (18a-c).

14. Method according to claim 13, wherein, in order to move the carrier body (4) from the access position (B) into the removal position (E), the carrier slide (5) of the optical module (1) is displaced along a support surface (17) of the housing (8).

## Revendications

1. Système optique (12) comprenant:
un module optique (1) comportant un premier corps porteur (4) auquel sont fixés au moins un élément optique (9, 10, 11), en particulier réfléchissant, pour guider un faisceau laser (2) et une pluralité de premiers éléments de montage (7a-c),
un boîtier (8), en particulier un boîtier sous vide, comportant un second corps porteur (19) pour au moins un autre élément optique (16) qui est conçu pour réfléchir un rayonnement EUV, une pluralité de seconds éléments de montage (18a-c) étant fixée au second corps porteur (19), et
un moyen de déplacement (21) pour faire coulisser le premier corps porteur (4) par rapport au second corps porteur (19) dans une direction de déplacement (23) en particulier verticale entre une position d'extraction (E), à partir de laquelle le module optique (1) peut être extrait du boîtier (8), et une position de montage (G), dans laquelle le moyen de déplacement (21) presse les premiers éléments de montage (7a-c) contre les seconds éléments de montage (18a-c).

2. Système optique selon la revendication 1, dans lequel le premier corps porteur (4) comprend un chariot porteur (5) qui est muni d'une pluralité de galets (6) et/ou d'éléments coulissants.

3. Système optique selon la revendication 2, dans lequel, dans la position d'extraction (E), les galets (6) et/ou les éléments coulissants reposent sur une surface d'appui (17) sur le boîtier (8) et, dans la position de montage (G), sont espacés de la surface d'appui (17).

4. Système optique selon l'une des revendications précédentes, dans lequel le module optique (1) comprend un composant de boîtier sous vide (13) pour fixer de manière étanche au vide le module optique (1) au boîtier sous vide (8).

5. Système optique selon la revendication 4, dans lequel le composant de boîtier sous vide (13) est relié au premier corps porteur (4) par un composant sous vide élastique (14).

6. Système optique selon l'une des revendications précédentes, dans lequel les premiers éléments de montage (7a-c) présentent au moins une surface de montage plane (24) et les seconds éléments de montage (18a-c) au moins une surface de montage courbe (26) ou inversement.

7. Système optique selon l'une des revendications précédentes, dans lequel le moyen de déplacement (21) comprend au moins un, de préférence une pluralité de moyens de levage (22a-c) pour presser chacun un premier élément de montage (7a-c) contre un second élément de montage (18a-c) qui lui est associé.

8. Système optique selon la revendication 7, dans lequel au moins un moyen de levage (22a-c) présente au moins un élément ressort précontraint (29).

9. Système optique selon la revendication 8, dans lequel au moins un moyen de levage (22a-c) présente une chambre de pression (31) qui peut être soumise à un fluide sous pression pour générer une force s'opposant à la précontrainte dudit au moins un élément ressort (29).

10. Système optique selon l'une des revendications précédentes, dans lequel ledit au moins un élément optique (9, 10, 11) du module optique (1) est conçu pour réfléchir un rayonnement laser.

11. Module optique (1) pour un système optique (12) selon l'une des revendications précédentes, comprenant :
un corps porteur (4) auquel sont fixés au moins un élément optique (9, 10, 11), en particulier réfléchissant, pour guider un faisceau laser (2) et une pluralité de premiers éléments de montage (7a-c), le corps porteur (4) présentant un chariot porteur (5) doté d'une pluralité de galets (6) et/ou d'éléments coulissants pour extraire le module optique (1) d'un boîtier (8), en particulier d'un boîtier sous vide.

12. Module optique selon la revendication 11, comprenant en outre : un composant de boîtier sous vide (13) qui est relié au corps porteur (4) par un composant sous vide élastique (14).

13. Procédé pour positionner en position correcte un module optique (1) dans un boîtier (8) d'un système optique (12) selon l'une des revendications 1 à 10, comprenant les étapes consistant à :
déplacer le corps porteur (4) du module optique (1) d'une position de mise à disposition (B) à une position d'extraction (E) dans le boîtier (8), et
déplacer le corps porteur (4) du module optique (1) de la position d'extraction (E) dans la position de montage (G) dans laquelle les premiers éléments de montage (7a-c) sont pressés contre les seconds éléments de montage (18a-c).

14. Procédé selon la revendication 13, dans lequel, pour déplacer le corps porteur (4) de la position de mise à disposition (B) dans la position d'extraction (E), on fait coulisser le chariot porteur (5) du module optique (1) le long d'une surface d'appui (17) du boîtier (8).
